Europäisches Patentamt

European Patent Office

Office européen des brevets

(11) Publication number: **0 649 221 A1**

# EUROPEAN PATENT APPLICATION

(21) Application number: **93308282.8**

(22) Date of filing: **18.10.93**

(51) Int. Cl.⁶: **H03H 19/00**

(43) Date of publication of application:
**19.04.95 Bulletin 95/16**

(84) Designated Contracting States:
**DE FR GB IT SE**

(71) Applicant: **NATIONAL SCIENCE COUNCIL**
**Fl. 18, No 106,**
**Sec. 2, Ho-Ping E. Road**
**Taipei (TW)**

(72) Inventor: **Wu, Chung-Yu**
**No. 75-1, PO-Ai St.**
**Hsinchu City (TW)**
Inventor: **Chang, Ying-Hwi**
**5F, No. 1, Alley 15, Lane 16,**
**Shiang-Ching Road**
**Chung-Ho City,**
**Taipei Hsien (TW)**
Inventor: **Yu, Tsai-Chung**
**2F, No. 3, Lane 153,**
**Han-Sheng W. Rd.**
**Pan-Chyau City,**
**Taipei Hsien (TW)**

(74) Representative: **Arthur, Bryan Edward**
**Withers & Rogers**
**4 Dyer's Buildings**
**Holborn**
**London EC1N 2JT (GB)**

(54) **Chopper-stabilized switched-capacitor filter.**

(57) A chopper-stabilized switched-capacitor filter (bk5) has a discrete-time sequence (bk16); and a discrete-time multiplier (bk6) connected to the dicrete-time sequence. The discrete-time multiplier receives an input signal (X), and multiplies it by the discrete-time sequence to produce a chopped input signal. A discrete-time filter (bk7) is connected to the discrete-time multiplier to receive and filter the chopped input signal, and produces a filtered output signal. The discrete-time filter may be a discrete-time high-pass or low-pass filter depending upon the desired function, e.g. low-pass or bandpass filtering function, of the chopper-stabilized switched-capacitor filter.

EP 0 649 221 A1

bk1

$c(n)=...,1,-1,1,-1,1,-1...$
bk12

$c(n)=...,1,-1,1,-1,1,-1,...$
bk14

bk3

bk2

x

Discrete-Time High-Pass
Filter

x'

y'

bk4

y

FIG. 1

bk5

$c(n)=...,1,-1,1,-1,1,-1...$
bk16

$c(n)=...,1,-1,1,-1,1,-1,...$
bk18

bk7

bk6

x

Discrete-Time Low-Pass
Filter

x'

y'

bk8

y

FIG. 2

2

BACKGROUND OF THE INVENTION

The present invention relates generally to a switched-capacitor filter, and more particularly to a chopper-stabilized switched-capacitor filter.

Switched-capacitor filters are very suitable to be implemented by IC (Integrated Circuits) technology, and thus have been widely used in VLSI (Very Large-Scale Integration) application products, especially for telecommunications. For example, they are applied to ISDN (Integrated Service Digital Network) U-Interfaces, 9600 MODEMs (Modem V.32, 9600 bps), mobile telephones, etc. Conventional switched-capacitor filters however exist several drawbacks.

For example, when the switched-capacitor filters are used in low-pass filtering applications, the low-frequency noises, such as the l/f noise, the offset voltage of operation amplifier, the charge injection noise, etc., seriously contaminate the output signal. Thus, these low-frequency noises will limit the dynamic range of a switched-capacitor filter and its more advanced applications. To decrease low-frequency noises in a switched-capacitor low-pass filter circuit, two kinds of solutions have been proposed. One solution substitutes chopper-stabilized operation amplifiers for traditional operational amplifiers in the filters. Such a technique is described in the article of K. Hsieh et al., "A Low-Noise Chopper-Stabilized Differential Switched-Capacitor Filtering Technique", *IEEE J. Solid−State Circuits*, vol. SC-16, no. 6, pp.708-715, Dec. 1981. Another solution utilizes the known "correlated double sampling technique". Since these two techniques approach the problem from a circuit perspective, they only reduce parts of the low-frequency noises.

In the other hand, when the switched-capacitor filters are used in bandpass filtering applications, they suffer from a high capacitor ratio problem, i.e. the capacitor ratio needed is very large. Further, since the bandpass center frequency is determined by the capacitor ratio and the gain of operational amplifier, the frequency response of the filter will be very sensitive to circuit components, so that the bandpass function of filters is easily affected by IC process variations. At present, there are two approaches to solve this problem. One approach proposes a very difficult filter design and a very special circuit method to lower its sensitivity to circuit components. Such a technique is described in the article of T. C. Choi et al., "High-Frequency COs Switched-Capacitor Filters for Communications Application" published in *IEEE J. Solid−State Circuits*, vol. SC-18, no. 6, pp. 652-664, Dec. 1983. Another approach, document in U.S. Patent Nos. 4,644,304 and 4,446,438, utilizes N-path filters. The former approach is too difficult to implement it easily, and the dynamic range of the latter approach is limited by accuracy of the capacitor ratio. Furthermore, these two approaches also intend to solve the problem from the circuit perspective, and thus the results are not really satisfactory

SUMMARY OF THE INVENTION

The primary object of the present invention is to provide a chopper-stabilized switched-capacitor filter which utilizes a "chopper" technique to solve the above-mentioned problems. The present invention solves the problems from the system perspective, quite differently from the circuit perspective formed in the prior art.

Another object of the present invention is to provide a chopper-stabilized switched-capacitor filter which can be applied in low-pass filtering to remove all circuit low-frequency noises, and, not only the noise of operational amplifier. Thus, the enlargement of the dynamic range of the switched-capacitor filter is excellent. Also, the chopper-stabilized switched-capacitor filter has simple circuit topology, is easy to design, and can be manufactured without any special IC process.

Further object of the present invention is to provide a chopper-stabilized switched-capacitor filter which can be applied in bandpass filtering to significantly reduce the capacitor ratio and the sensitivity of the filter frequency response to circuit components without having to resort to a difficult filter design or special circuit methods. Furthermore, the dynamic range of chopper-stabilized switched-capacitor filter, unlike a N-path filter, need not depend on accuracy of the capacitor ratio.

In accordance with the present invention, a chopper-stabilized switched-capacitor filter comprises a first discrete-time sequence; a first discrete-time multiplier connected to the first discrete-time sequence, and adapted to receive an input signal, the first discrete-time multiplier multiplying the input signal by the first discrete-time sequence to produce a chopped input signal; and a discrete-time filter connected to the first discrete-time multiplier to receive and filter the chopped input signal so as to produce a filtered output signal.

According to one aspect of the present invention, the discrete-time filter is a discrete-time high-pass filter, so that the chopper-stabilized switched-capacitor filter is a low-pass filter.

According to another aspect of the present invention, the discrete-time filter is a discrete-time low-pass filter, so that the chopper-stabilized switched-capacitor filter is a bandpass filter.

In both preferred embodiments, the first discrete-time sequence may be consisted of alternating "1" and "-1" signals. The chopper-stabilized switched-capacitor filter may further comprises a second discrete-time sequence, and a second discrete-time multiplier connected to the second discrete-time sequence and the discrete-time filter to receive and multiply the filtered output signal by the second discrete-time sequence so as to produce a chopped output signal. In addition, the second discrete-time sequence is consisted of alternating "1" and "-1" signals.

BRIEF DESCRIPTION OF THE DRAWINGS

The present invention can be more fully understood by reference to the following description and accompanying drawings, which form an integral part of this application:

Fig. 1 is a schematic block diagram of a chopper-stabilized switched-capacitor low-pass filter structure according to a first preferred embodiment of the present invention;

Fig. 2 is a schematic block diagram of a chopper-stabilized switched-capacitor bandpass filter structure according to a second preferred embodiment of the present invention;

Fig. 3(a) to 3(d) illustrate the signal characteristics of the chopper-stabilized switched-capacitor low-pass filter structure of Fig. 1;

Fig. 4 is a schematic block diagram of a conventional two-order switched-capacitor low-pass filter circuit;

Fig. 5 is a schematic block diagram of a 2nd-order chopper-stabilized switched-capacitor low-pass filter circuit, based on the structure shown in Fig. 1;

Fig. 6(a) is an electrical circuit schematic diagram of a 2nd-order switched-capacitor low-pass filter, designed on the basis of the conventional function blocks as shown in Fig. 4;

Fig. 6(b) depicts the control clocks indicated in the low-pass filter circuit of Fig. 6(a);

Fig. 7(a) is an electrical circuit schematic diagram of a two-order chopper-stabilized switched-capacitor low-pass filter, designed on the basis of the function blocks as shown in Fig. 5;

Fig. 7(b) shows the control clocks indicated in the low-pass filter circuit of Fig. 7(a);

Fig. 8 shows the simulation results of conventional circuit of Fig. 6, which uses traditional operational amplifiers (i.e. not chopper-stabilized operational amplifiers);

Fig. 9 shows the simulation results of conventional circuit of Fig. 6, which uses chopper-stabilized operational amplifiers;

Fig. 10 shows the simulation results of the present circuit of Fig. 7, which uses traditional operation amplifiers (i.e. not chopper-stabilized operation amplifiers);

Fig. 11(a) to 11(d) illustrate the signal characteristics of the chopper-stabilized switched-capacitor bandpass filter structure of Fig. 2;

Fig. 12 is a schematic block diagram of a chopper-stabilized switched-capacitor bandpass filter circuit, designed on the basis of the structure as shown in Fig. 2;

Fig. 13(a) is an electrical circuit schematic diagram of a chopper-stabilized switched-capacitor band-pass filter, designed on the basis of the function blocks as shown in Fig. 12; and

Fig. 13(b) shows the control clocks indicated in the bandpass filter circuit of Fig. 13(a).

DETAILED DESCRIPTION OF THE PREFERRED EMBODIMENTS

As known in this art, a switched-capacitor filter is a discrete-time filter, and its relationship between input and output signals, i.e. its transfer function, can be described as $H(z)$ in z-domain, wherein $z = e^{j\omega}$, and $\omega$ is an angular frequency. The relationship between $\omega$ and the frequency $f$ of a continuous signal can be characterized by $\omega = 2\pi f/f_s$, wherein $f_s$ is the sampling frequency of the system. The sampling frequency $f_s = 1/T$, wherein T is the sampling period. If the frequency of the continuous signal $f = f_s/2$, the angular frequency $\omega = \pi$. In this specification, it should be noted that the description for the switched-capacitor filter is in z-domain.

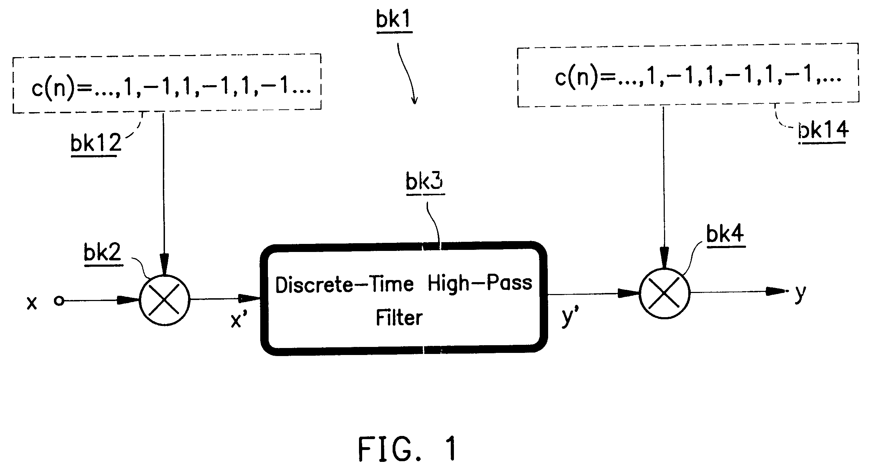

Referring now to Fig. 1, there is shown a chopper-stabilized switched-capacitor low-pass filter structure according to a first preferred embodiment of the present invention. It should be noted that main principle of the present invention is a so-called "chopper" technique, which can be applied to low-pass and bandpass filtering and will be described in detail later. The chopper-stabilized switched-capacitor low-pass filter structure bk1 includes a discrete-time sequence bk12 consisting of alternating "1" and "-1" digital signals; a discrete-time multiplier bk2 receiving and multiplying a low-frequency input signal x and the discrete-time sequence bk12 to produce a signal x' at its output terminal; and a discrete-time high-pass filter bk3 is connected to the multiplier bk2 to receive and filter the signal x' and to generate a filtered signal y' at its output terminal. The relationship between the transfer function $H'(z)$ of discrete-time high-pass filter bk3 and desired transfer function $H(z)$ of entire low-pass filter structure bk1 can be described as $H'(z) = H(-z)$. The chopper-stabilized switched-capacitor low-pass filter structure bk1 futher includes a discrete-time sequence bk14 consisting of alternating "1" and "-1" digital signals; and a discrete-time multiplier bk4 receiving and multiplying the output signal y' of the discrete-time high-pass filter bk3 and the discrete-time sequence bk14 to produce a final signal y of the entire filter bk1. The transfer function of entire low-pass filter structure bk1 equals to the desired transfer function H(z). This can be proven easily by the following mathematical operations:

$$H(z) = H'(-z), X(z) = X'(-z),$$
$$Y'(z) = X'(z)H'(z),$$
$$Y(z) = Y'(-z) = X'(-z)H'(-z) = X(z)H(z).$$

This means that the filter structure of Fig. 1 can obtain the same transfer function as coventional switched-capacitor low-pass filters.

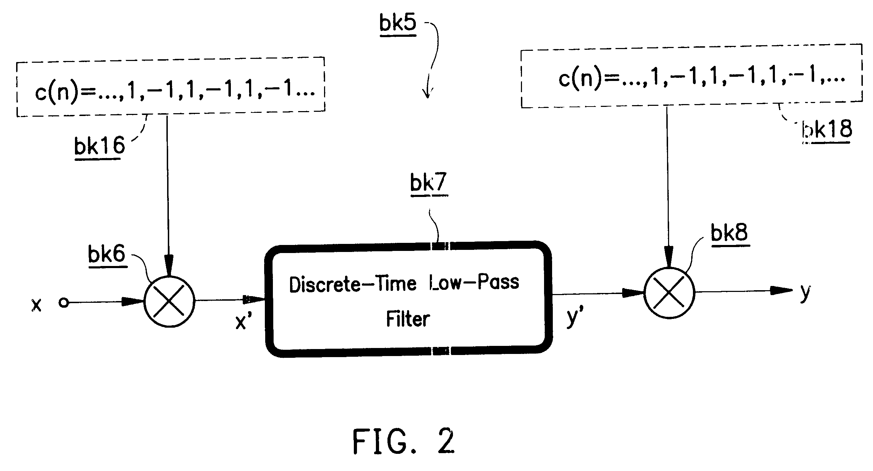

Referring to Fig. 2, there is shown a chopper-stabilized switched-capacitor bandpass filter structure according to a second preferred embodiment of the present invention. It should be noted that this embodiment also utilizes the "chopper" technique of the present invention. The chopper-stabilized switched-capacitor bandpass filter structure bk5 includes a discrete-time sequence bk16 consisting of alternating "1" and "-1" digital signals; a discrete-time multiplier bk6 receiving and multiplying a bandpass input signal x and the discrete-time sequence bk16 to produce a signal x' at its output terminal; and a discrete-time low-pass filter bk7 connected to the multiplier bk6 to receive and filter the signal x' and to generate a filtered signal y' at its output terminal. The relationship between the transfer function **H'(z)** of discrete-time low-pass filter bk7 and desired transfer function **H(z)** of entire bandpass filter structure bk5 can be characterized as H'(z) = H(-z). The chopper-stabilized switched-capacitor bandpass filter structure bk5 futher includes a discrete-time sequence bk18 consisting of alternating "1" and "-1" digital signals; and a discrete-time multiplier bk8 receiving and multiplying the output signal y' of the discrete-time low-pass filter bk7 and the discrete-time sequence bk18 to produce a final signal y of entire filter bk5. The transfer function of entire bandpass filter structure bk5 equals to the desired transfer function H(z). This can be proven easily by the following mathematical operations:

$$H(z) = H'(-z), X(z) = X'(-z),$$
$$Y'(z) = X'(z)H'(z),$$
$$Y(z) = Y'(-z) = X'(-z)H'(-z) = X(z)H(z).$$

This means that the filter structure of Fig. 2 can obtain the same transfer function as coventional switched-capacitor bandpass filters.

It should be noted that the bandpass filter structure bk 5 of Fig. 2 is quite similar to the low-pass filter structure bk1 of Fig. 1. The only difference is the discrete-time filter. The bandpass filter structure bk5 uses a discrete-time low-pass filter while the low-pass filter structure bk1 uses a discrete-time high-pass filter.

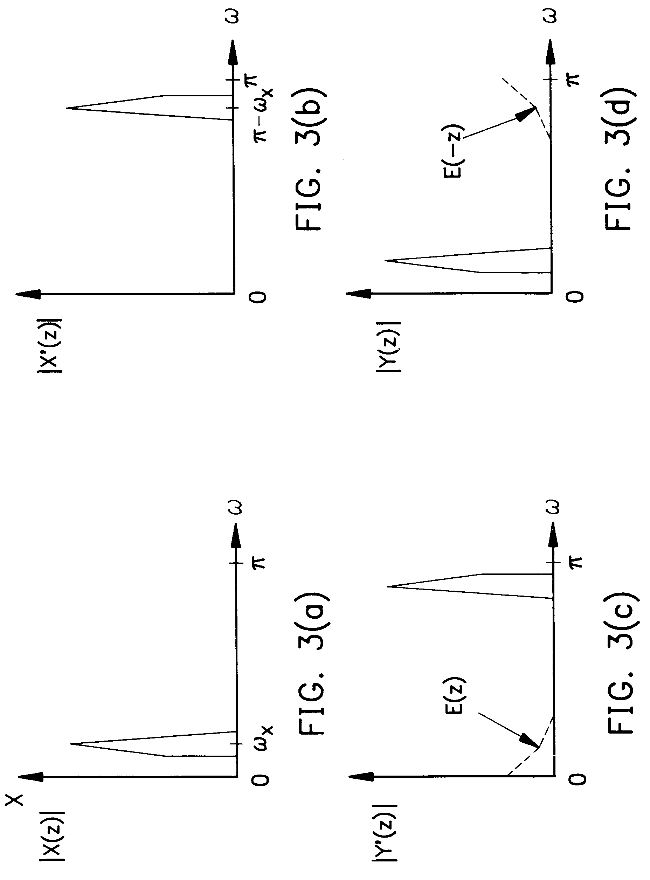

Referring to Figs. 1 and 3(a)-3(d), the operations and functions of respective parts of chopper-stabilized switched-capacitor low-pass filter structure bk1 will be described in more detail. When the structure bk1 is used for low-pass filtering, the block bk3 of Fig. 1 is a discrete-time high-pass filter. Figs. 3(a)-3(d) are schematic diagrams of the half-spectrums of signals x, x', y', and y in the chopper-stabilized switched-capacitor low-pass filter structure bk1. The multiplication operation performed by the discrete-time multiplier bk2 is called "chopper" multiplication, and can modulate the low-frequency input signal x having a center frequency at $\omega_x$, as shown in Fig. 3(a), into the signal x' having a center frequency at $(\pi-\omega_x)$, as shown in Fig. 3(b). When the signal x' passes through the discrete-time high-pass filter bk3, circuit low-frequency noise e(n) appears. Fig. 3(c) shows the half-spectrum of the signal y', and the z-domain transfer function of the low-frequency noise e(n) is E(z) as shown in Fig. 3(c). The "chopper" multiplication of the discrete-time multiplier bk4 chops the output signal y' of the discrete-time high-pass filter bk3 to produce finally desired signal y. The spectrum of signal y is shown in Fig. 3(d). In this way, the circuit low-frequency noise is chopped to high-frequency area by the "chopper" multiplication of discrete-time multiplier bk4, and does not exist in low-frequency region and thus does not affect the dynamic range. This can be proven by the following mathematical operations:

$$H(z) = H'(-z), X(z) = X'(-z),$$
$$Y'(z) = X'(z)H'(z) + E(z),$$
$$Y(z) = Y'(-z) = X'(-z)H'(-z) + E(-z) = X(z)H(z) + E(-z).\quad (A)$$

From equation (A), it can be clearly seen that the noise item in the output signal is E(-z). Since the noise item E(-z) is a high-frequency item, it will not contaminate the output signal.

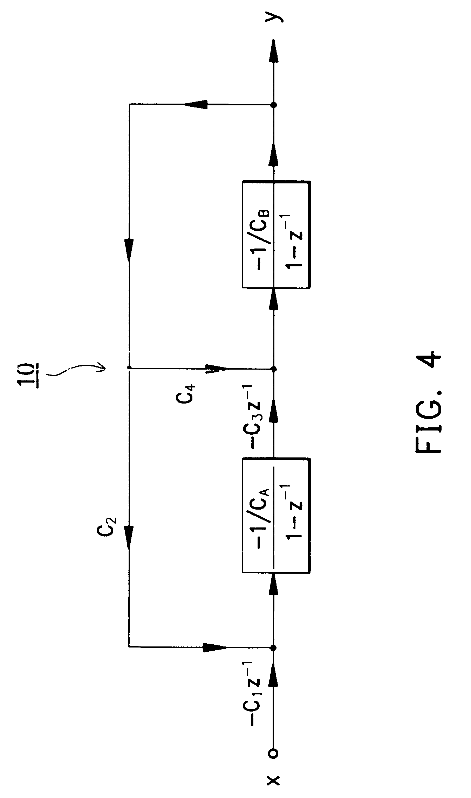

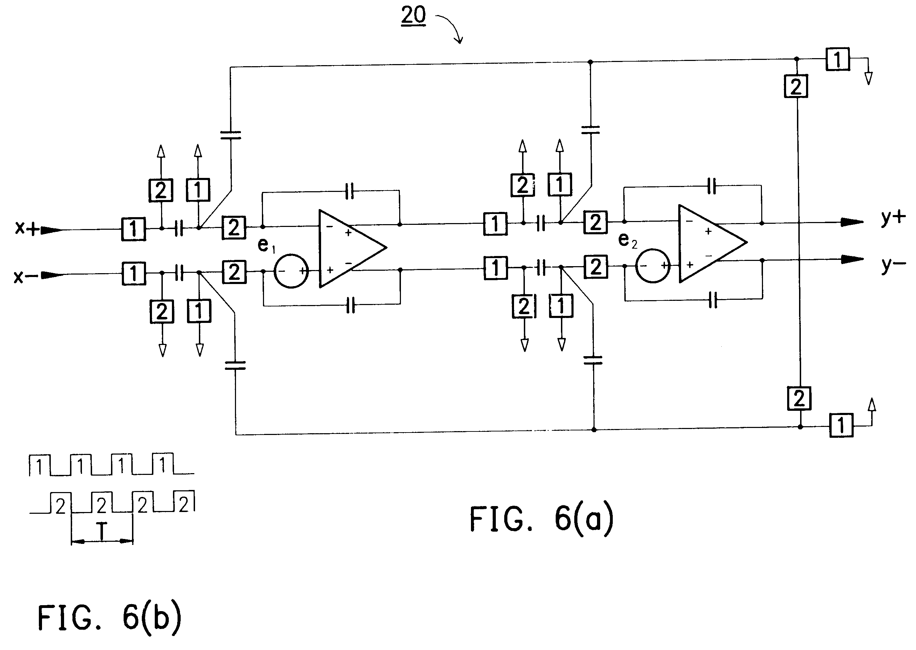

In order to verify the advantages of the present invention, the inventor utilizes a conventional switched-capacitor filter and one example of the present chopper-stabilized switched-capacitor filter to do simulation comparisons. Fig. 4 shows a schematic block diagram of a conventional 2nd-order switched-capacitor low-pass filter circuit 10, wherein the z-domain transfer functions can be implemented by suitable known circuits. Fig. 6(a) shows an electrical circuit schematic diagram of a 2nd-order switched-capacitor low-pass filter 20, designed on the basis of the block diagram 10 of Fig. 4. The control clocks **"1"** and **"2"** identified in Fig. 6(a) are clearly shown in Fig. 6(b). The period T shown in Fig. 6(b) corresponds to the system sampling frequency. The control clocks **"1"** and **"2"**

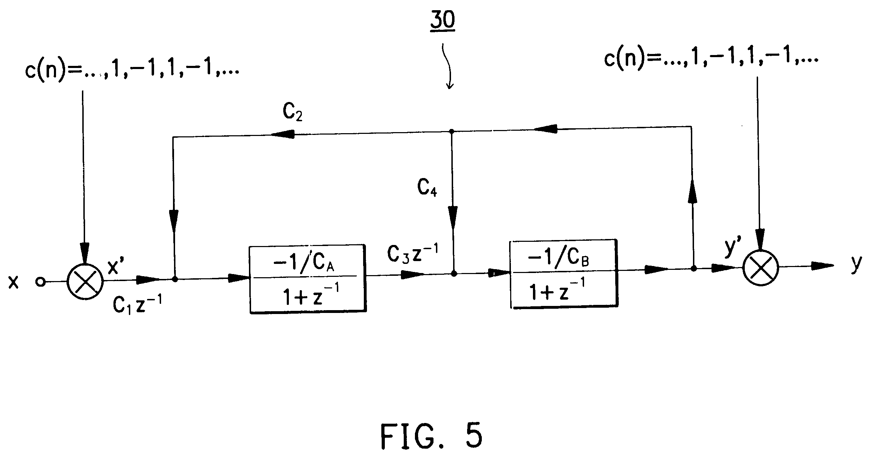

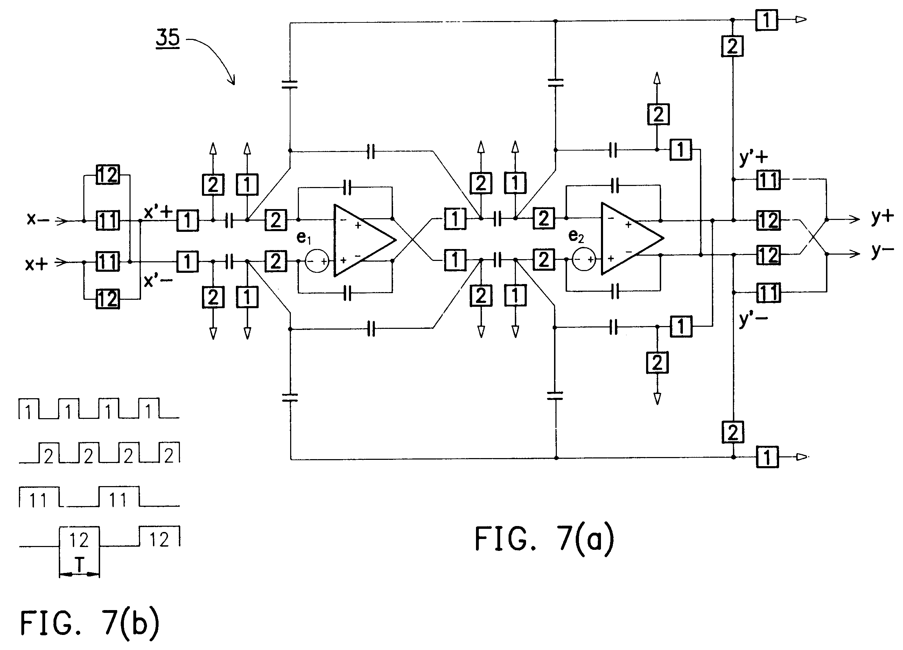

have same sampling period T, and are not overlapped by each other. Fig. 5 shows a schematic block diagram of a 2nd-order chopper-stabilized switched-capacitor low-pass filter circuit 30, which is based on the structure bk1 of Fig. 1 and can obtain the same filtering function as will the circuit 10 of Fig. 4. The z-domain symbols transfer functions in Fig. 5 can be implemented by suitable known circuits. Fig. 7(a) shows an electrical circuit schematic diagram of a 2nd-order chopper-stabilized switched-capacitor low-pass filter 35, designed on the basis of the block diagram 30 of Fig. 5. The control clocks **"1"**, **"2"**, **"11"** and **"12"** indicated in Fig. 7(a) are clearly shown in Fig. 7(b). The period T shown in Fig. 7(b) also corresponds to the system sampling frequency. The control clocks **"1"** and **"2"** are the same as those shown in Fig. 6(b). The control clocks **"11"** and **"12"** have same sampling period 2T, and are not overlapped by each other while overlapping the clocks **"1"** and **"2"**. As shown in Fig. 7(a), the clocks **"11"** and **"12"** control the polarities of signal input and output to implement the discrete-time sequences (bk12 and bk14) and multipliers (bk2 and bk4 ) of Fig. 1. The discrete-time high-pass filter bk3 can be achieved by conventional switched-capacitor filter design.

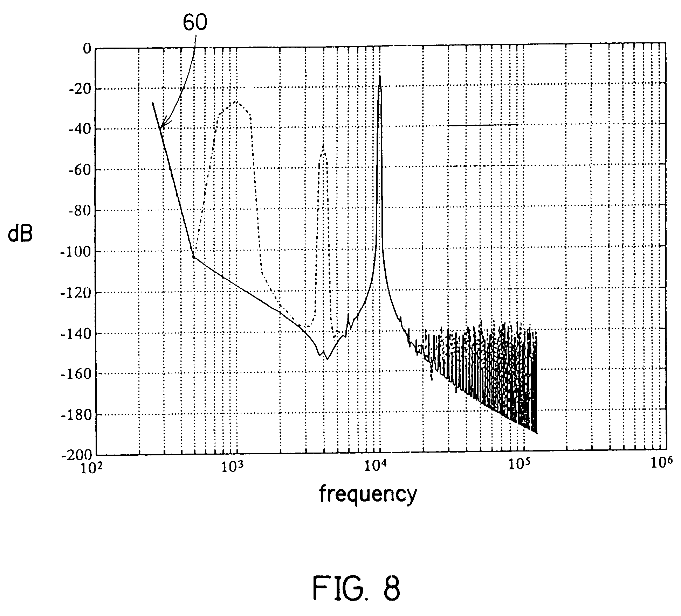

Then, the circuits of Figs. 6(a) and 7(a) are used as the basis to do simulations. The simulations make use of the switched-capacitor circuit simulator software known as SWICAP II developed by K. Suyama and S. C. Fang of Columbia University, U.S.A. Equivalent noise voltage sources $e_1$ and $e_2$ needed by the simulation are added in front of respective operational amplifiers as shown in Figs. 6(a) and 7(a). In order to ensure unbalanced noise effects, the switch of upper circuit part simulates a switch having charge injection noise effect while the switch of lower circuit part simulates an ideal switch. Thus, noise in upper circuit part will not offset the noise in lower circuit part. In simulation, the input signal is a sinusoidal wave of 10 KHz frequency, and the sampling frequency is 1024 KHz. There are 4096 output signals sampled for spectrum analysis. The first simulation is a noise free condition, i.e. with $e_1 = e_2 = 0$, and the second simulation is a noisy condition, wherein $e_1$ is a 1 KHz sinusoidal wave while $e_2$ is a 4 KHz sinusoidal wave. The simulation results are shown in Figs. 8 through 10. In these figures, the results of the first simulation are plotted in phantom lines, while the results of second simulation are plotted in solid lines.

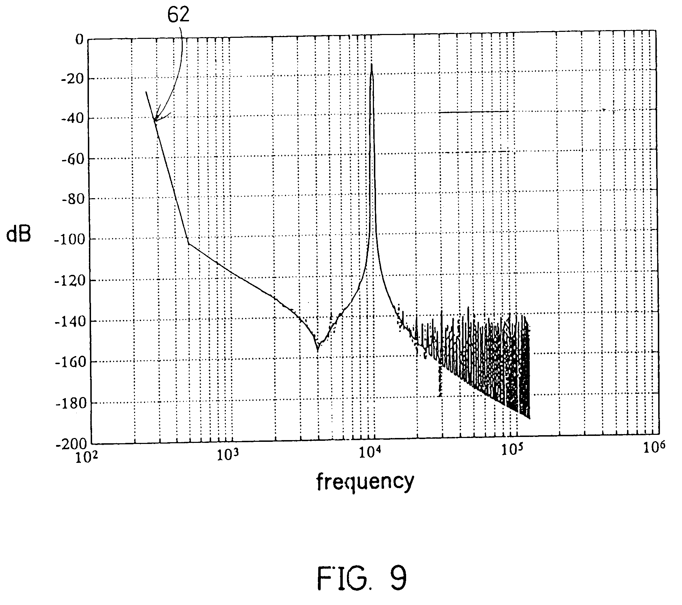

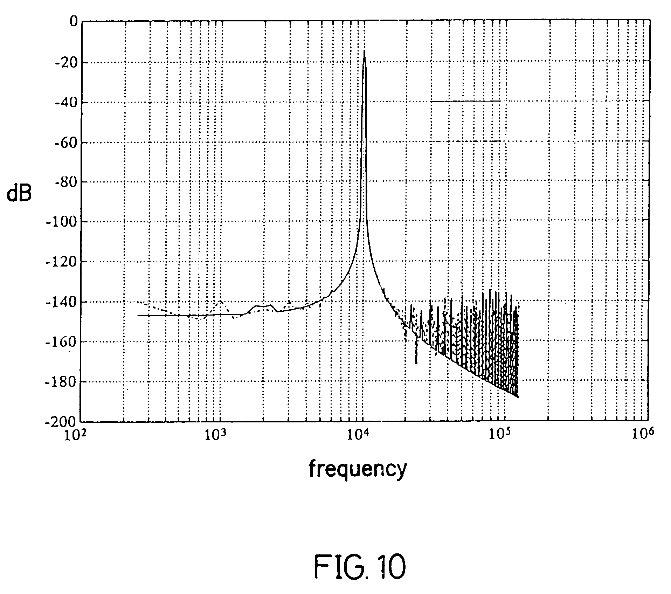

Fig. 8 shows the simulation results of the conventional switched-capacitor low-pass filter 20 of Fig. 6(a), which uses traditional operational amplifiers, i.e. not chopper-stabilized operational amplifiers. Fig. 9 shows the simulation results of conventional switched-capacitor low-pass filter 20 of Fig. 6(a), which uses chopper-stabilized operational amplifiers. It can be clearly seen in Figs. 8 and 9 that the output signal of conventional switched-capacitor low-pass filter, no matter what kind of operational amplifiers are used, is always contaminated by the operational amplifier noise or charge injection noise, as indicated by numeral 60 in Fig. 8 or numeral 62 in Fig. 9. Fig. 10 shows the simulation results of the present chopper-stabilized switched-capacitor low-pass filter 35 of Fig. 7(a) , which uses traditional operational amplifiers, i.e. not chopper-stabilized operation amplifiers. It can be clearly seen in the drawing that the output signals in the noise free and noisy conditions are almost the same. That is to say, the output signal of the present chopper-stabilized switched-capacitor low-pass filter, even using traditional operational amplifiers, is not contaminated by low-frequency noises.

It has been verified from both theoretical derivation and computer simulation that the present invention was very low from low-frequency noise, so that the dynamic range of switched-capacitor low-pass filter is significantly increased. Thus, the present invention is very suitable to be applied to high-resolution switched-capacitor low-pass filter circuits.

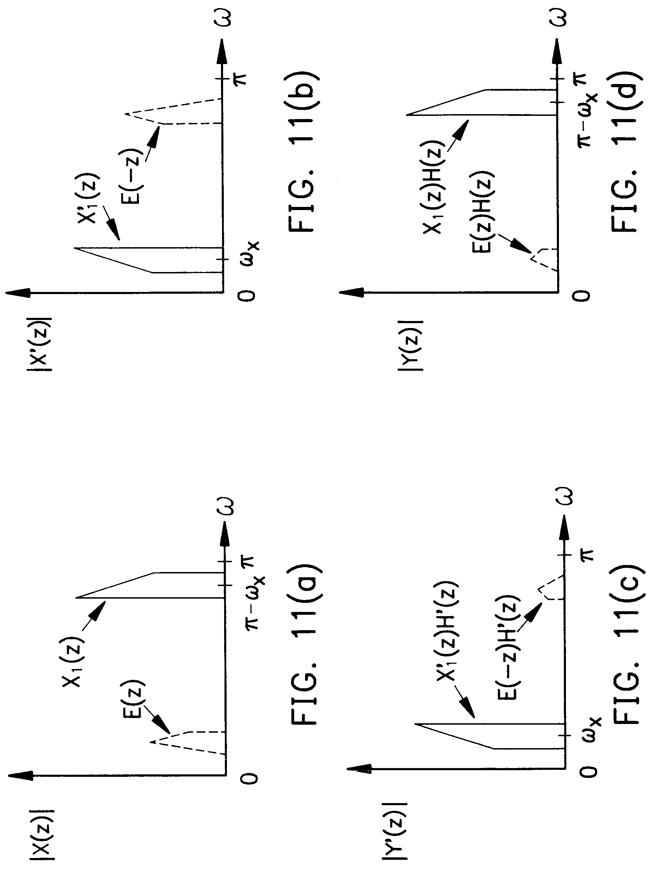

Referring to Figs. 2 and 11(a)-11(d), the operations and functions of respective parts of chopper-stabilized switched-capacitor bandpass filter structure bk5 will be described in more detail. When the structure bk5 is applied to bandpass filtering, the block bk7 of Fig. 2 is a discrete-time low-pass filter. The center frequency of bandpass signal in the structure bk5 is half of the system sampling frequency, i.e. the angular frequency $\pi$-$\omega_x$. Figs. 11(a)-11(d) are diagrams of the half-spectrums of signals x, x', y', and y in the chopper-stabilized switched-capacitor bandpass filter structure bk5. As shown in Fig. 11(a), the input signal x includes a bandpass signal $x_1$ having a center frequency at $\pi$-$\omega_x$ and a non-bandpass signal e. The "chopper" multiplication conducted by the discrete-time multiplier bk6 modulates the input signal x into the signal x', wherein the bandpass signal $x_1$ with center frequency at $\pi$-$\omega_x$ is modulated into a signal $x_1$' with center frequency at $\omega_x$, and the non-bandpass signal e is modulated into a high-frequency signal e', as shown in Fig. 11(b). Then, the signal x' passes through the discrete-time low-pass filter bk7 to complete the low-pass filtering function. Fig. 11-(c) shows the half-spectrum of the output signal y' of the discrete-time low-pass filter bk7. The "chopper" multiplication of the discrete-time multiplier bk8 chops the output signal y' to produce the finally desired signal y. The spectrum of signal y is shown in Fig. 11(d). It can be shown that the

bandpass signal $x_1$ can pass through the filter, and the bandpass filtering is obtained. In addition, the non-bandpass input signal e is attenuated. This can be proven by the following mathematical operations:

$$X(z) = X_1(z) + E(z),$$
$$X'(z) = X_1'(z) + E(-z), X_1'(z) = X_1(-z)$$
$$Y'(z) = X'(z)H'(z), H(z) = H'(-z), X(z) = X'(-z),$$
$$Y(z) = Y'(-z) = X'(-z)H'(-z) = X(z)H(z)$$
$$Y(z) = X_1(z)H(z) + E(z)H(z) \qquad (B)$$

From equation (B), it can be clearly seen that the non-bandpass input signal is attenuated to $E(z)H(z)$ in output signal. The bandpass input signal $X_1(z)$ passes through the filter, so that the bandpass filtering function is evidenced.

It should be noted that the filter block bk7 of chopper-stabilized switched-capacitor bandpass filter structure bk5 is a low-pass filter, not a bandpass filter, when the present invention is applied to bandpass filtering. However, the chopper-stabilized switched-capacitor bandpass filter structure bk5 still can provide the desired bandpass filtering function. The specification of needed low-pass filter bk7 is the same as the specification of the bandpass filter to be designed, except that its center frequency is moved to zero frequency from angular frequency $\pi$. Therefore, the filter design is simplified significantly. Furthermore, since the present structure bk5 does not use a conventional bandpass filter, the above-mentioned problems of conventional switched-capacitor bandpass filter, including very large capacitor ratio, and sensitivity of filter frequency response to circuit components, no longer exist.

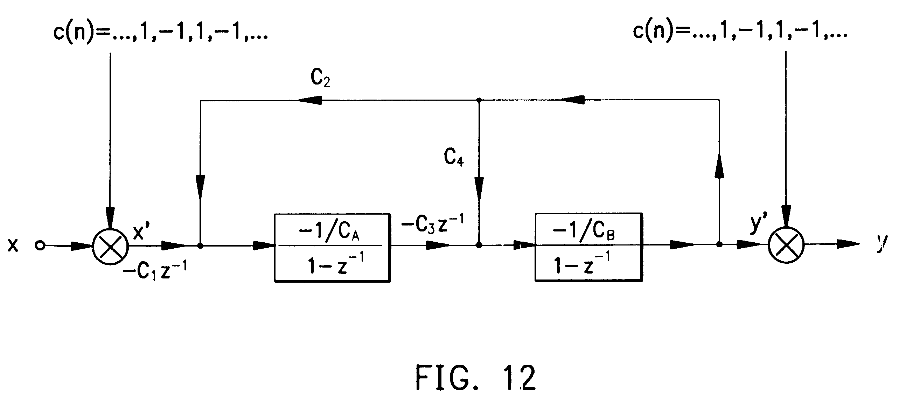

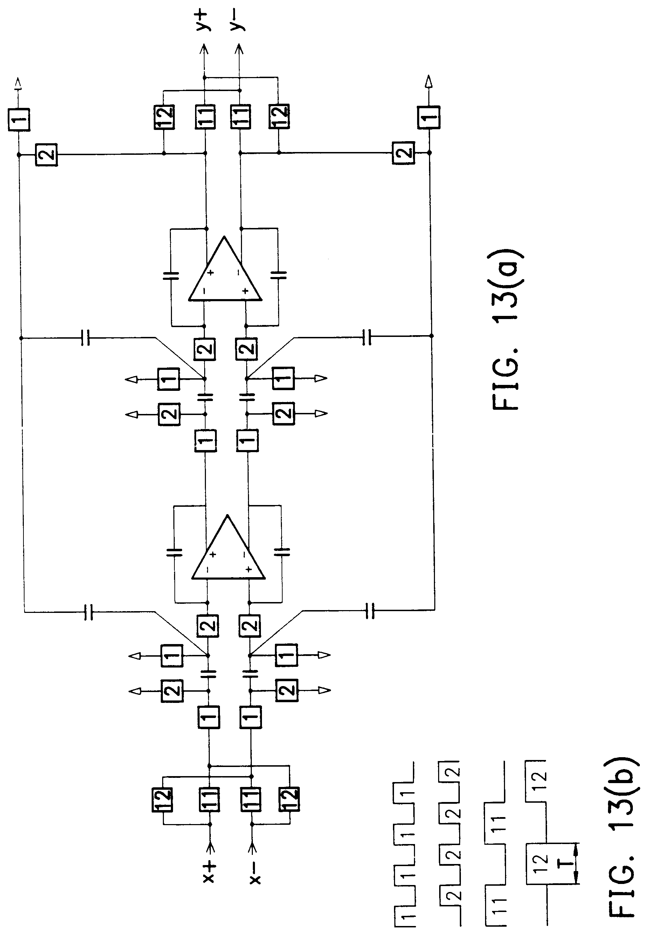

Fig. 12 shows a schematic block diagram of a chopper-stabilized switched-capacitor bandpass filter circuit, designed on the basis of the structure bk5 as shown in Fig. 2. The z-domain transfer functions in Fig. 12 can be implemented by suitable known cirucits. Fig. 13(a) shows a chopper-stabilized switched-capacitor bandpass filter example based on the circuit of Fig. 12. The control signals **"1"**, **"2"**, **"11"**, and **"12"** indicated in Fig. 13(a) are shown in Fig. 13(b), and they are the same as those shown in Fig. 7(b). As shown in Fig. 13(a), the clocks **"11"** and **"12"** control the polarities of signal input and output to implement the discrete-time sequences (bk16 and bk18) and multipliers (bk6 and bk8) of Fig. 2. The discrete-time low-pass filter bk7 may be achieved by a conventional switched-capacitor low-pass filter design, as is shown in Fig. 6.

It should be understood that although both discrete-time sequences bk12 and bk16 in Figs. 1 and 2 are described as a sequence consisting of alternating **"1"** and **"-1"** signals, different discrete-time sequences may be used in the present invention to obtain similar "chopper" operation. It should be also understood that the discrete-time sequences and multipliers bk14; bk4 and bk18; bk8 in Figs. 1 and 2 may be optionally used in other signal processing circuits connected behind the filter of the present invention. That is to say, the chopper-stabilized switched-capacitor filter of the present invention may omit the discrete-time sequences and multipliers bk14; bk4 and bk18; bk8.

While the invention has been described in terms of what is presently considered to be the most practical and preferred embodiments, it is to be understood that the invention need not be limited to the disclosed embodiments. On the contrary, it is intended that various modifications and similar arrangements be included within the spirit and scope of the appended claims, the scope of which should be accorded the broadest interpretation so as to encompass all such modifications and similar structures.

**Claims**

1. A chopper-stabilized switched-capacitor filter comprising:
   a first discrete-time sequence;
   a first discrete-time multiplier connected to said first discrete-time sequence, and adapted to receive an input signal, said first discrete-time multiplier multiplying said input signal by said first discrete-time sequence to produce a chopped input signal; and
   a discrete-time filter connected to said first discrete-time multiplier to receive and filter said chopped input signal so as to produce a filtered output signal.

2. A chopper-stabilized switched-capacitor filter as claimed in claim 1, wherein said discrete-time filter is a discrete-time high-pass filter, so that said chopper-stabilized switched-capacitor filter is a low-pass filter.

3. A chopper-stabilized switched-capacitor filter as claimed in claim 1, wherein said discrete-time filter is a discrete-time low-pass filter, so that said chopper-stabilized switched-capacitor filter is a bandpass filter.

4. A chopper-stabilized switched-capacitor filter as claimed in claim 2, wherein said first discrete-time sequence is consisted of alternating **"1"** and **"-1"** signals.

5. A chopper-stabilized switched-capacitor filter as claimed in claim 4, further comprising a second discrete-time sequence, and a second discrete-time multiplier connected to said second discrete-time sequence and said discrete-time filter to receive and multiply said filtered output signal by said second discrete-time sequence so as to produce a chopped output signal.

6. A chopper-stabilized switched-capacitor filter as claimed in claim 5, wherein said second discrete-time sequence is consisted of alternating "1" and "-1" signals.

7. A chopper-stabilized switched-capacitor filter as claimed in claim 3, wherein said first discrete-time sequence is consisted of alternating "1" and "-1" signals.

8. A chopper-stabilized switched-capacitor filter as claimed in claim 7, further comprising a second discrete-time sequence, and a second discrete-time multiplier connected to said second discrete-time sequence and said discrete-time filter to receive and multiply said filtered output signal by said second discrete-time sequence so as to produce a chopped output signal.

9. A chopper-stabilized switched-capacitor filter as claimed in claim 8, wherein said second discrete-time sequence is consisted of alternating "1" and "-1" signals.

EP 0 649 221 A1

bk1

c(n)=...,1,−1,1,−1,1,−1...

bk12

c(n)=...,1,−1,1,−1,1,−1,...

bk14

bk3

bk2

x ○——————⊗——→ x' —→ **Discrete-Time High-Pass Filter** → y' ——⊗——→ y

bk4

FIG. 1

bk5

c(n)=...,1,−1,1,−1,1,−1...

bk16

c(n)=...,1,−1,1,−1,1,−1,...

bk18

bk7

bk6

bk8

x

Discrete−Time Low−Pass Filter

x'

y'

y

FIG. 2

EP 0 649 221 A1

X

|X(z)|

0    $\omega_x$                    $\pi$    $\omega$

FIG. 3(a)

|X'(z)|

0                    $\pi-\omega_x$  $\pi$    $\omega$

FIG. 3(b)

|Y'(z)|

E(z)

0                         $\pi$    $\omega$

FIG. 3(c)

|Y(z)|

E(−z)

0                         $\pi$    $\omega$

FIG. 3(d)

FIG. 4

FIG. 5

FIG. 6(a)

FIG. 6(b)

EP 0 649 221 A1

FIG. 7(a)

FIG. 7(b)

FIG. 8

FIG. 9

FIG. 10

EP 0 649 221 A1

FIG. 11(a)

FIG. 11(b)

FIG. 11(c)

FIG. 11(d)

FIG. 12

FIG. 13(a)

FIG. 13(b)

21

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | ELECTRONICS LETTERS. vol. 29, no. 21 , 14 October 1993 , ENAGE GB pages 1844 - 1845 XP404311 B.K. MARLOW ET AL 'HIGHLY SENSITIVE CAPACITANCE MEASUREMENT FOR SENSORS' | 1 | H03H19/00 |
| A | * the whole document * | 2,5-9 | |

|  | TECHNICAL FIELDS SEARCHED (Int.Cl.6) |
|---|---|
|  | H03H |

The present search report has been drawn up for all claims

| Place of search | Date of completion of the search | Examiner |
|---|---|---|
| THE HAGUE | 22 March 1994 | Coppieters, C |